# EUROPEAN PATENT APPLICATION

(11) **EP 4 611 258 A1**
(43) Date of publication of application: **03.09.2025**
(21) Application number: 25158993.3
(22) Date of filing: 20.02.2025
(51) Int. Cl.: H02S 50/15

(54) **INSPECTION APPARATUS**

(30) Priority: 22.02.2024 KR 20240025915
(71) Applicant: Hanwha Solutions Corporation, Jung-gu Seoul 04541 (KR)
(72) Inventor: JUNG, Min Kyo, Seoul 04541 (KR); CHUNG, Dong Jin, Seoul 04541 (KR)
(74) Representative: Mooser, Sebastian Thomas

(57) **Abstract**

An inspection apparatus includes a first grip unit on which a solar cell string having a solar cell and a wire is mounted, a second grip unit that is disposed to face the first grip unit and presses the solar cell string toward the first grip unit, a power supply unit that is connected to the second grip unit and supplies a current to the solar cell string, and a detection unit that acquires image information on the solar cell string.

## Description

### BACKGROUND

### 1. Field of the Invention

The present disclosure relates to an inspection apparatus, and more specifically, to an inspection apparatus capable of inspecting a solar cell string, which is manufactured in a tabbing process, for defects.

### 2. Discussion of Related Art

Generally, a solar cell is formed by arranging p-n junction diodes on a substrate. When a solar cell is irradiated with sunlight, an exciton, which is an electron-hole pair, is generated, and as the exciton is divided, the electron moves to an n layer, the hole moves to a p layer, and thus photovoltaic power is generated at a p-n junction portion.

Generally, a maximum voltage of a single solar cell is only about 0.5 V, and thus multiple solar cells have to be connected in series to be used. A device in which multiple unit solar cells are connected and modularized is called a solar cell module.

A tabbing process is a process of arranging wires on a plurality of solar cells and electrically connecting the plurality of solar cells to form a single solar cell module.

A visual inspection, an electroluminescence (EL) inspection, etc. may be performed to inspect the quality of the solar cells manufactured in the tabbing process.

In the case of a visual inspection, the surface quality of the solar cells may be visually evaluated by a worker. In the case of an EL inspection, the quality of the solar cells may be measured by inspecting the electroluminescence image of the solar cells generated by applying an electric field to the solar cells.

The related art of the present disclosure is disclosed in Korean Patent Publication No. 10-1058399 (registered on August 16, 2011, title of the invention: Tabber-stringer and tabbing-stringing method).

### SUMMARY OF THE INVENTION

The present disclosure is directed to providing an inspection apparatus capable of inspecting a solar cell string, which is manufactured in a tabbing process, for defects.

According to an aspect of the present disclosure, there is provided an inspection apparatus including: a first grip unit on which a solar cell string having a solar cell and a wire is mounted; a second grip unit that is disposed to face the first grip unit and presses the solar cell string toward the first grip unit; a power supply unit that is connected to the second grip unit and supplies a current to the solar cell string; and a detection unit that acquires image information on the solar cell string.

The first grip unit and the second grip unit may be disposed to face each other in a vertical direction.

The first grip unit may include: a first grip body; and a first gripper that extends from the first grip body and comes into contact with the wire.

A cross-sectional area of the first gripper may decrease toward the solar cell string.

The first gripper may be movably connected to the first grip body, and the first grip unit may further include an elastic member provided between the first gripper and the first grip body.

The first grip unit further may include a guide groove which is formed to be recessed inward of the first gripper and into which the wire is inserted.

The second grip unit may include: a second grip body that is spaced apart from the first grip body and generates a driving force; and a second gripper that is moved by receiving the driving force from the second grip body and presses or releases the wire toward or from the first gripper depending on a movement direction.

The second grip unit may further include a pressing protrusion that protrudes from the second gripper and comes into contact with the wire.

A cross-sectional area of the pressing protrusion may be smaller than a cross-sectional area of the second gripper.

According to another aspect of the present disclosure, there is provided an inspection apparatus including: a first adsorption member that adsorbs a first surface of a solar cell string; a first driving unit that adjusts a position of the first adsorption member; a second adsorption member that is spaced apart from the first adsorption member and adsorbs a second surface opposite to the first surface adsorbed to the first adsorption member; and a second driving unit that adjusts a position of the second adsorption member.

The first driving unit may include: a first driving body; and a first rotating body that supports the first adsorption member and is rotatably connected to the first driving body, and the first rotating body may rotate the first adsorption member such that the second surface faces the second adsorption member after the first adsorption member absorbs the first surface.

The second driving unit may include: a second driving body that is spaced apart from the first driving body and is installed to move relative to the first driving body; and a second rotating body that is rotatably connected to the second driving body and supports the second adsorption member, and the second rotating body may rotate the second adsorption member such that the first surface faces in a set direction after the second adsorption member has absorbed the second surface.

According to still another aspect of the present disclosure, there is provided an inspection apparatus including: a supply unit that supplies a solar cell string; a transfer unit that transfers the solar cell string supplied from the supply unit; and an inspection unit that acquires an electroluminescence image of the solar cell string transferred from the transfer unit.

The solar cell string may include a first surface and a second surface which are opposite to each other, and the transfer unit may include: a first adsorption member that adsorbs the first surface; a first driving unit that adjusts a position of the first adsorption member; a second adsorption member that is spaced apart from the first adsorption member and adsorbs the second surface of the solar cell string adsorbed to the first adsorption member; and a second driving unit that adjusts a position of the second adsorption member.

The solar cell string may include a solar cell and a wire, and the inspection unit may include; a first grip unit on which the solar cell string is mounted; a second grip unit that is disposed to face the first grip unit, is connected to the transfer unit, and presses the solar cell string toward the first grip unit; a power supply unit that is connected to the second grip unit and supplies a current to the solar cell string; and a detection unit that acquires image information on the solar cell string.

### BRIEF DESCRIPTION OF THE DRAWINGS

The above and other objects, features and advantages of the present disclosure will become more apparent to those of ordinary skill in the art by describing exemplary embodiments thereof in detail with reference to the accompanying drawings, in which:
FIG. 1 is a schematic view showing a configuration of an inspection apparatus according to one embodiment of the present disclosure;
FIG. 2 is an enlarged view schematically showing a configuration of a first grip unit and a second grip unit according to one embodiment of the present disclosure;
FIG. 3 is an enlarged view schematically showing the configuration of the first grip unit and the second grip unit according to one embodiment of the present disclosure from a different point of view from FIG. 2;
FIG. 4 is a cross-sectional view schematically showing a configuration of an elastic member according to one embodiment of the present disclosure;
FIG. 5 is a schematic view showing a configuration of a guide groove according to one embodiment of the present disclosure;
FIG. 6 is a schematic view showing a configuration of a pressing protrusion according to one embodiment of the present disclosure;
FIGS. 7 and 8 are schematic views showing an operation process of the inspection apparatus according to one embodiment of the present disclosure;
FIGS. 9 and 10 are schematic views showing a configuration of an inspection apparatus according to another embodiment of the present disclosure;
FIGS. 11 to 15 are schematic views showing an operation process of the inspection apparatus according to another embodiment of the present disclosure;
FIGS. 16 and 17 are schematic views showing a configuration of an inspection apparatus according to still another embodiment of the present disclosure; and
FIGS. 18 and 19 are schematic views showing an EL inspection process according to still another embodiment of the present disclosure.

### DETAILED DESCRIPTION OF EXEMPLARY EMBODIMENTS

Hereinafter, exemplary embodiments of the present disclosure will be described in detail with reference to the accompanying drawings. Prior to this, terms or words used in this specification and claims should not be interpreted as limited to their usual or dictionary meanings and should be interpreted as meanings and concepts that conform to the technical idea of the present disclosure based on the principle that the inventor can appropriately define the concepts of the terms in order to describe his or her own invention in the best way. Therefore, the embodiments described in this specification and the configurations illustrated in the drawings are only some of the most preferred embodiments of the present disclosure and do not represent all of the technical ideas of the present disclosure, and it should be understood that there may be various equivalents and modified examples that can replace them at the time of filing this application. Additionally, when used in this specification, the terms "comprise," "include," "comprising," and/or "including" specify the presence of described shapes, numbers, steps, operations, members, elements, and/or groups thereof, and do not exclude the presence or addition of one or more other shapes, numbers, operations, members, elements, and/or groups thereof. Additionally, when describing embodiments of the present disclosure, "may" and "may be" may include "one or more embodiments of the present disclosure."

Additionally, to aid understanding of the invention, the attached drawings are not drawn to scale, and the dimensions of some components may be exaggerated. Additionally, the same reference numbers may be given to the same components in different embodiments.

The description that two comparison targets are "the same" means that they are "substantially the same." Therefore, "substantially the same" may include deviations that are considered low in the art, for example, deviations of less than 5%. Additionally, uniformity of a parameter over a given region may be uniformity from the viewpoint of an average.

First, second, etc. are used to describe various components, and it should be understood that these components are not limited by these terms. These terms are used only to distinguish one component from another component, and unless otherwise specified, it should be understood that a first component may also be a second component.

Throughout the specification, unless otherwise specified, each element may be singular or plural.

Any component being disposed "on an upper portion (or on lower portion)" of a component or "above (or below)" a component may mean not only that any component is disposed in contact with an upper surface (or an lower surface) of the component, but also that another component may be interposed between the component and any component disposed above (or below) the component.

Additionally, when a first component is described as being "connected," "coupled," or "joined" to a second component, it should be understood that the components may be directly connected or joined to each other, but that a third component may also be "interposed" between the components, or that the components may be "connected," "coupled," or "joined" through the third component. In addition, when a portion is electrically coupled to another portion, this includes not only a case where they are directly connected, but also a case where they are connected with another element interposed therebetween.

Throughout the specification, "A and/or B" means A, B, or A and B, unless otherwise specified. That is, "and/or" includes all or any combination of the listed items. "C to D" means C or more and D or less, unless otherwise specified.

When phrases such as "at least one of A, B, and C," "at least one of A, B, or C," "at least one selected from the group consisting of A, B, and C," and "at least one selected from A, B, and C" are used to specify a list of elements A, B, and C, the phrases may refer to any suitable combination.

The term "use" may be considered to be synonymous with the term "utilize." As used in this specification, the terms "substantially," "about," and "similar" are used as terms of approximation rather than as terms of degree and are intended to take into account the inherent variation in measured or calculated values that will be recognized by those skilled in the art.

In this specification, although the terms first, second, third, etc. may be used to describe various elements, components, regions, layers, and/or sections, these elements, components, regions, layers, and/or sections should not be limited by these terms. These terms are used to distinguish one element, component, region, layer, or section from another element, component, region, layer, or section. Accordingly, a first element, component, region, layer, or section to be described below may be referred to as a second element, component, region, layer, or section without departing from the teachings of the exemplary embodiments.

For ease of description, spatially relative terms such as "beneath," "below," "lower," "above," "upper," and the like may be used in this specification to describe the relationship of one element or feature to (an)other element(s) or feature(s) as illustrated in the drawings. Spatially relative positions will be understood to encompass different orientations of a device in use or operation in addition to the orientation depicted in the drawings. For example, when a device in a drawing is turned over, an element described as "below" or "on a lower portion of" another element is understood to be "above" or "on an upper portion of" another element. Therefore, the term "below" can encompass both the upward and downward directions.

The terms used in this specification are for the purpose of describing embodiments of the present disclosure and are not intended to limit the present disclosure.

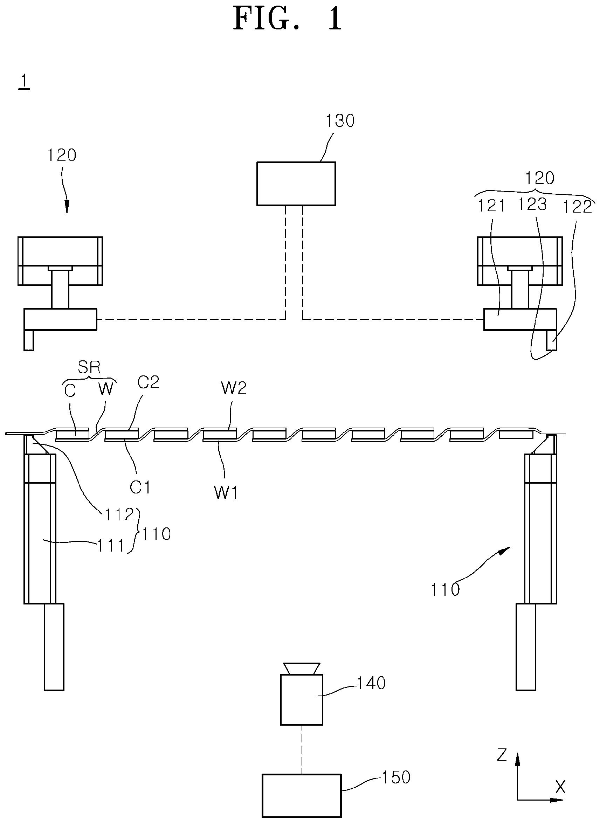

FIG. 1 is a schematic view showing a configuration of an inspection apparatus according to one embodiment of the present disclosure.

Referring to FIG. 1, an inspection apparatus 1 according to the present embodiment is an apparatus for performing an electroluminescence (EL) inspection to acquire an EL image of a solar cell string SR manufactured through a tabbing process and includes first grip units 110, second grip units 120, a power supply unit 130, and a detection unit 140.

The EL inspection is a method of inspecting the quality of the solar cell string SR using an electroluminescence phenomenon in which the solar cell string SR emits light when a current flows therethrough.

The solar cell string SR may include solar cells C and wires W.

The solar cell C has a semiconductor junction region having a p-n junction surface, and when a certain amount of energy or more is applied thereto, an electromotive force is generated to convert light energy into electrical energy. A material of a semiconductor included in the solar cell C is not particularly limited, and silicon (single crystalline, polycrystalline, or amorphous silicon), gallium arsenide, cadmium tellurium, cadmium sulfide, indium phosphide, copper indium gallium selenide (CIGS), an organic dye, or a mixture thereof may be used.

The solar cell C may include a first surface C1 and a second surface C2, which are opposite to each other. The first surface C1 and the second surface C2 may function as a positive electrode and a negative electrode of the solar cell C, respectively. The first surface C1 may be a main light-receiving surface of the solar cell C that directly receives light radiated from the sun. The solar cell C may be a single-sided solar cell that generates power using light received through only the first surface C1 or a double-sided solar cell that generates power using light received through both the first surface C1 and the second surface C2.

A first surface C1 and a second surface C2 of the solar cell string SR to be described below may be the same surfaces as the first surface C1 and the second surface C2 of the solar cell C.

A plurality of solar cells C may be provided. The plurality of solar cells C may be arranged in a first direction. The first direction to be described below may be a direction horizontal to the ground and parallel to an X axis based on FIG. 1.

The wire W may function as a conductor for electrically connecting the plurality of solar cells C to each other. The wire W may electrically connect a pair of solar cells C disposed adjacent to each other in a solar cell module.

The wire W may extend longitudinally in the first direction. The wire W may be disposed such that both sides thereof face a pair of adjacent solar cells C in the first direction. For example, the wire W may include a first portion W1 facing the first surface C1 of one of the adjacent solar cells C and a second portion W2 facing the second surface C2 of the other one thereof.

A plurality of wires W may be provided. The plurality of wires W may be individually disposed between adjacent solar cells C.

The first grip unit 110 and the second grip unit 120 may function as components for gripping the wire W of the solar cell string SR to support the solar cell string SR at a position spaced a certain distance from the ground.

The first grip unit 110 and the second grip unit 120 may be disposed to face each other in a vertical direction. Accordingly, since the first grip unit 110 and the second grip unit 120 align a gripping direction of the wire W with a direction parallel to the direction of gravity, the first grip unit 110 and the second grip unit 120 can be in stable contact with the wires W, and the solar cell string SR can be firmly supported.

Hereinafter, an example in which the first grip unit 110 is disposed below the second grip unit 120 will be described. However, the first grip unit 110 and the second grip unit 120 are not limited thereto, and the first grip unit 110 may also be disposed above the second grip unit 120.

A plurality of first grip units 110 and a plurality of second grip units 120 may be provided. The plurality of first grip units 110 and the plurality of second grip units 120 may be arranged in a direction parallel to an extension direction of the solar cell string SR, that is, the first direction.

For example, as shown in FIG. 1, a pair of first grip units 110 and a pair of second grip units 120 may be provided. The pair of first grip units 110 and the pair of second grip units 120 may individually grip the first portion W1 of the wire W disposed at one end portion of the solar cell string SR and the second portion W2 of a wire W disposed at the other end portion of the solar cell string SR.

The first grip unit 110 may be provided such that the solar cell string SR is mounted thereon and may support the solar cell string SR above the ground. When the solar cell string SR is mounted on the first grip unit 110, the solar cell string SR may be disposed such that the first surface C1 faces downward.

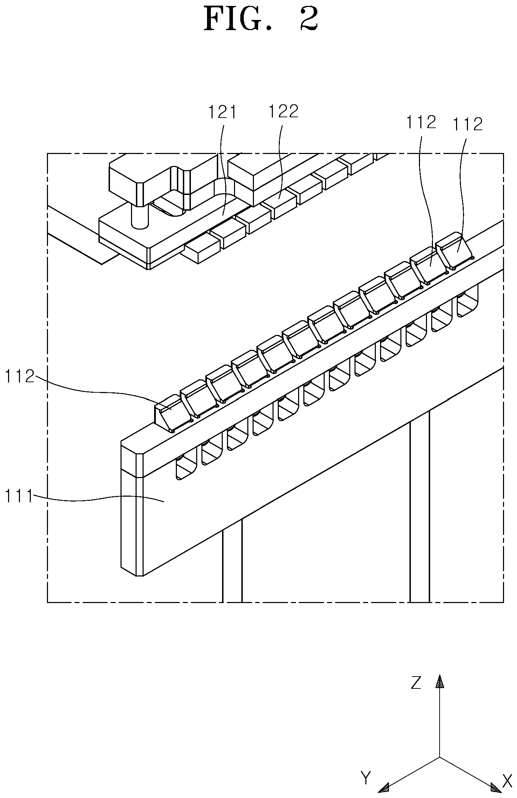

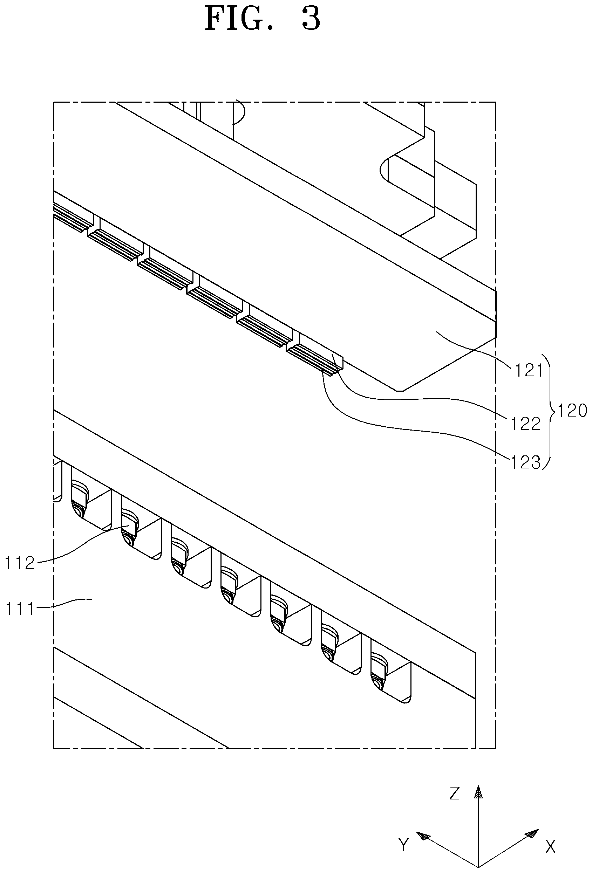

FIG. 2 is an enlarged view schematically showing a configuration of the first grip unit and the second grip unit according to one embodiment of the present disclosure, and FIG. 3 is an enlarged view schematically showing the configuration of the first grip unit and the second grip unit according to one embodiment of the present disclosure from a different point of view from FIG. 2.

Referring to FIGS. 1 to 3, the first grip unit 110 may include a first grip body 111 and a first gripper 112.

The first grip body 111 may form the substantial appearance of the first grip unit 110 and support the first gripper 112.

The first grip body 111 according to the present embodiment may be disposed at a position spaced a predetermined distance upward from the ground. The first grip body 111 may be supported by being fixed to a pillar or frame extending from the ground. The first grip body 111 may be disposed such that a longitudinal direction thereof is parallel to a second direction. Here, the second direction may be a direction that is horizontal to the ground, intersects with the first direction, and is parallel to a Y axis based on FIG. 2.

An upper surface of the first grip body 111 may be disposed to face a lower side surface of the wire W extending from the end portion of the solar cell string SR. More specifically, a pair of first grip bodies 111 provided in the pair of first grip units 110 may be disposed to face a lower side surface of the first portion W1 of the wire W extending from one end portion of the solar cell string SR and a lower side surface of the second portion W2 of the wire W extending from the other end portion of the solar cell string SR.

A specific shape of the first grip body 111 is not limited to the shape shown in FIGS. 2 and 3, and various design changes are possible within the technical concept of a shape capable of supporting the first gripper 112.

The first gripper 112 may extend from the first grip body 111 and come into contact with the wire W.

The first gripper 112 according to the present embodiment may extend upward from the first grip body 111. An upper surface of the first gripper 112 may come into contact with the lower side surface of the wire W.

An area of the upper surface of the first gripper 112 parallel to the second direction may be larger than a diameter of the wire W. A cross-sectional area of the first gripper 112 may be formed to decrease toward the solar cell string SR, that is, toward an upper side. Accordingly, the first gripper 112 may increase pressure applied to the wire W per unit area to support the wire W more firmly together with the second grip unit 120 which will be described below.

A plurality of first grippers 112 may be provided. The plurality of first grippers 112 may be formed on each first grip body 111. The first gripper 112 extending from any one first grip body 111 of the pair of first grip bodies 111 may come into contact with the lower side surface of the first portion W1 of the wire W extending from one end portion of the solar cell string SR. The first gripper 112 extending from any one first grip body 111 of the pair of first grip bodies 111 may come into contact with the lower side surface of the second portion W2 of the wire W extending from the other end portion of the solar cell string SR.

A plurality of wires W may be disposed in parallel in the second direction on any one solar cell C. In this case, the plurality of first grippers 112 may be formed on each first grip body 111 in a number corresponding to the number of wires W disposed in parallel in the second direction. The plurality of first grippers 112 formed on any one first grip body 111 may be arranged in the second direction and individually come into contact with the wires W disposed in parallel in the second direction, respectively.

The first gripper 112 may be formed of an electrically conductive material such as steel, copper, aluminum, nickel, etc.

The first gripper 112 may be movably connected to the first grip body 111. For example, the first gripper 112 may be connected to the first grip body 111 to vertically pass through the first grip body 111 and reciprocate in the vertical direction.

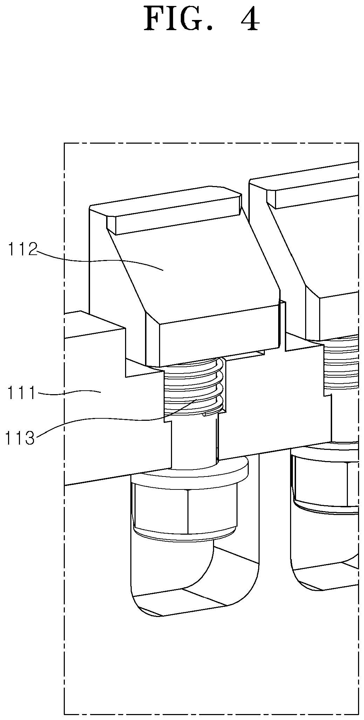

FIG. 4 is a cross-sectional view schematically showing a configuration of an elastic member according to one embodiment of the present disclosure.

Referring to FIG. 4, the first grip unit 110 according to the present embodiment may further include an elastic member 113.

The elastic member 113 may be provided between the first gripper 112 and the first grip body 111 and elastically support the first gripper 112 with respect to the first grip body 111. The elastic member 113 according to the present embodiment may be formed to have a shape of a coil spring that may be compressed and stretched in a longitudinal direction thereof. The elastic member 113 may be disposed such that a longitudinal direction thereof is parallel to the vertical direction. Both end portions of the elastic member 113 may be fixed to the first gripper 112 and the first grip body 111. When an external force is applied downward to the first gripper 112, the first gripper 112 may move downward and compress the elastic member 113. When the external force applied to the first gripper 112 is removed, the elastic member 113 may be stretched by the accumulated elastic restoring force, and the first gripper 112 may be moved upward. Accordingly, the elastic member 113 may absorb the impact caused when the first gripper 112 comes into contact with the wire W or caused by a pressing force applied from the second grip unit 120, which will be described below, by its own elastic restoring force.

A plurality of elastic members 113 may be provided. Each elastic member 113 may be installed to independently elastically support different first grippers 112 with respect to the first grip body 111.

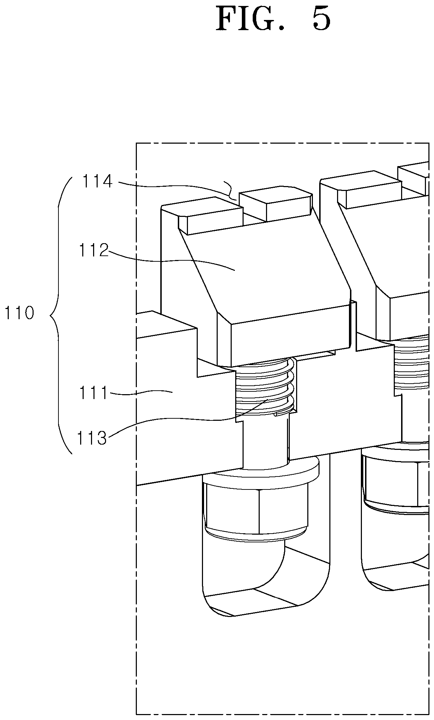

FIG. 5 is a schematic view showing a configuration of a guide groove according to one embodiment of the present disclosure.

Referring to FIG. 5, the first grip unit 110 according to the present embodiment may further include a guide groove 114.

The guide groove 114 may function as a component that prevents the wire W from being separated from the first gripper 112.

The guide groove 114 according to the present embodiment may be formed to have a groove shape that is recessed from the upper surface of the first gripper 112 toward the inside of the first gripper 112. The guide groove 114 may pass through both surfaces of the first gripper 112 perpendicular to the first direction. When the wire W is mounted on the first gripper 112, the wire W may be inserted into the guide groove 114. The cross-sectional shape, curvature, etc. of the guide groove 114 may be formed to correspond to the cross-sectional shape and curvature of the wire W.

The second grip unit 120 may be disposed to face the first grip unit 110. The second grip unit 120 may function as a component that presses the solar cell string SR toward the first grip unit 110 to grip and fix the wire W together with the first grip unit 110.

The second grip unit 120 according to the present embodiment may include a second grip body 121 and a second gripper 122.

The second grip body 121 may be spaced apart from the first grip unit 110 and support the second gripper 122. The second grip body 121 may generate a driving force to move the second gripper 122 which will be described below.

The second grip body 121 according to the present embodiment may be disposed above the first grip body 111. The second grip body 121 may include various types of actuators such as a motor, a cylinder, etc. that receive power, hydraulic pressure, etc. from the outside to generate a driving force. An upper end portion of the second grip body 121 may be coupled to a separate frame (not shown) or the like and positionally fixed. A lower end portion of the second grip body 121 may be connected to the second grip body 121 to be movable in the vertical direction. The lower end portion of the second grip body 121 may be reciprocally moved in the vertical direction by an operation of a power device and change a position of the second gripper 122. However, the shape of the second grip body 121 is not limited to this, and various design changes are possible within the technical concept of generating a driving force to move the second gripper 122 which will be described below.

A pair of second grip bodies 121 may be provided. Each second grip body 121 may be individually disposed above different first grip bodies 111.

The second gripper 122 may be moved by receiving the driving force from the second grip body 121 and press or release the wire W toward the first gripper 112 depending on a movement direction.

The second gripper 122 according to the present embodiment may be connected to the lower end portion of the second grip body 121. The second gripper 122 may be disposed to face the first gripper 112 with the solar cell string SR interposed therebetween.

More specifically, a plurality of second grippers 122 may be provided. The plurality of second grippers 122 may be individually connected to the pair of second grip bodies 121. The second grippers 122 connected to any one of the pair of second grip bodies 121 may be disposed to face an upper side surface of the first portion W1 of the wire W extending from one end portion of the solar cell string SR. The second grippers 122 connected to any one of the pair of second grip bodies 121 may be disposed to face an upper side surface of the second portion W2 of the wire W extending from the other end portion of the solar cell string SR.

The plurality of second grippers 122 may be formed on each second grip body 121 in a number corresponding to the number of wires W disposed in parallel in the second direction. The plurality of second grippers 122 formed on one second grip body 121 may be arranged in the second direction. The plurality of second grippers 122 arranged in the second direction may be disposed to individually face different first grippers 112 with the wires W disposed in parallel in the second direction interposed therebetween.

The second gripper 122 may press the wire W downward toward the first gripper 112 as the lower end portion of the second grip body 121 moves downward. Accordingly, the wire W may be fixed between the first gripper 112 and the second gripper 122 by the pressing forces applied in opposite directions from the first gripper 112 and the second gripper 122.

The second gripper 122 may release the pressing force applied to the wire W as the lower end portion of the second grip body 121 moves upward.

The second gripper 122 may be formed of an electrically conductive material such as steel, copper, aluminum, nickel, etc.

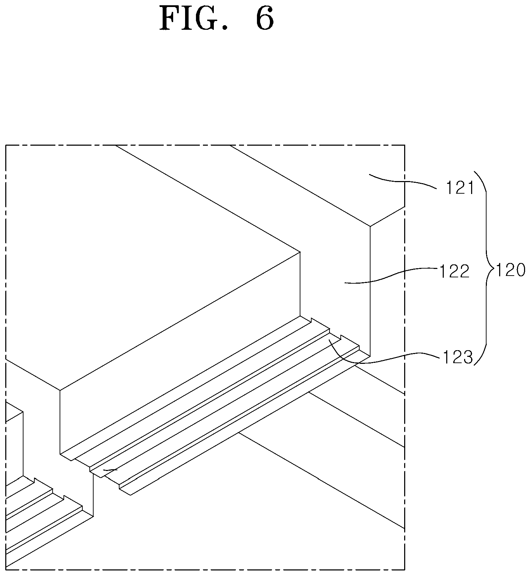

FIG. 6 is a schematic view showing a configuration of a pressing protrusion according to one embodiment of the present disclosure.

The pressing protrusion 123 may protrude downward from a lower surface of the second gripper 122. The pressing protrusion 123 may come into contact with the upper side surface of the wire W as the second gripper 122 moves downward toward the first gripper 112.

A cross-sectional area of the pressing protrusion 123 may be smaller than a cross-sectional area of the second gripper 122. Accordingly, the pressing protrusion 123 may increase the pressure applied to the wire W per unit area such that the wire W is further firmly fixed between the first gripper 112 and the second gripper 122.

The pressing protrusion 123 may be disposed such that a longitudinal direction thereof is parallel to a direction intersecting the extension direction of the wire W, i.e., the second direction. Accordingly, the pressing protrusion 123 may simultaneously press a plurality of wires W disposed in parallel in the second direction. A plurality of pressing protrusions 123 may be provided. The plurality of pressing protrusions 123 may be arranged in the extension direction of the wire W, i.e., the first direction.

In the above, an example in which the second grip unit 120 includes the pressing protrusion 123 has been described, but the second grip unit 120 is not limited thereto, and the second gripper 122 may come into direct contact with the wire W.

The power supply unit 130 may be connected to the second grip unit 120. The power supply unit 130 may apply a current to the solar cell string SR through the second grip unit 120. The power supply unit 130 according to the present embodiment may include any current source or voltage source that applies a preset value of current to the solar cell string SR.

The power supply unit 130 may be electrically connected to the second gripper 122. More specifically, a positive terminal of the power supply unit 130 may be connected to the second gripper 122 provided in one of the pair of second grip units 120, and a negative terminal of the power supply unit 130 may be connected to the second gripper 122 provided in the other of the pair of second grip units 120. Accordingly, the current applied from the power supply unit 130 may be sequentially transmitted through one of the pair of second grip units 120, the solar cell string SR, and the other of the pair of second grip units 120.

The detection unit 140 may acquire image information on the solar cell string SR. The detection unit 140 according to the present embodiment may include a camera capable of capturing an electroluminescence image of the solar cell string SR. For example, the camera may be an infrared camera that captures infrared rays emitted from the solar cell string SR as the current is applied to the solar cell string SR and outputs an image of each area of the solar cell string SR based on the captured infrared rays. However, the camera is not limited thereto, and it is possible to use various types of image capturing devices capable of capturing an electroluminescence image of the solar cell string SR.

The detection unit 140 may be disposed between the pair of first grip bodies 111. The detection unit 140 may be disposed to face the first surface C1 of the solar cell string SR. The detection unit 140 may acquire image information on the first surface C1 when a current is applied to the solar cell string SR.

The inspection apparatus 1 according to the present embodiment may further include a control unit 150. The control unit 150 according to the present embodiment may detect whether the solar cell string SR is defective based on the image of the solar cell string SR acquired from the detection unit 140. For example, the control unit 150 may determine the quality of the solar cell string SR to be poor when the brightness distribution of the solar cell cells C constituting the solar cell string SR is not uniform. The control unit 150 may determine a portion where brightness is significantly low in the brightness distribution of the cells to be a portion where a crack has occurred or to be in a state in which the connection between the solar cell C and the wire W is not smooth.

The control unit 150 may be implemented by a central processing unit (CPU) or a system on chip (SoC), run an operating system or application, control a plurality of hardware or software components connected to a processor, and perform various types of data processing and operations. A control device may execute at least one command stored in a memory and store execution result data in the memory.

Hereinafter, an operation process of the inspection apparatus 1 according to one embodiment of the present disclosure will be described.

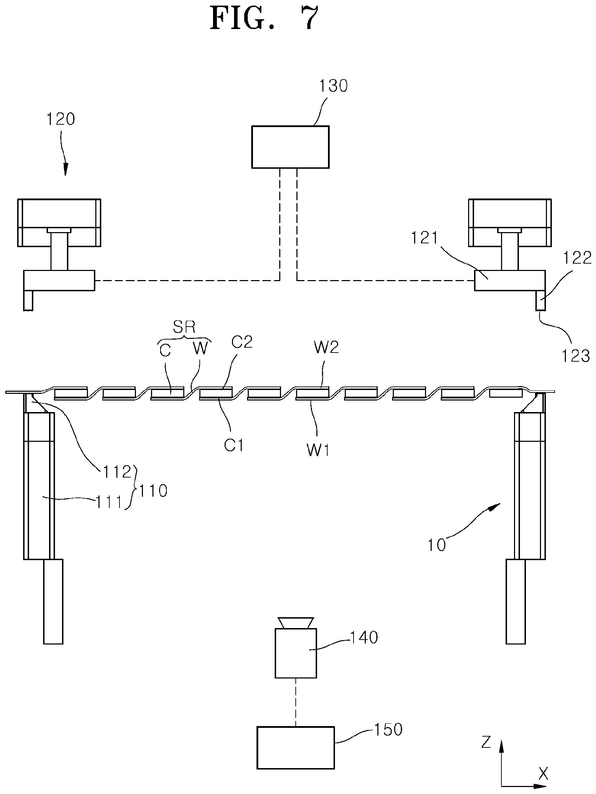

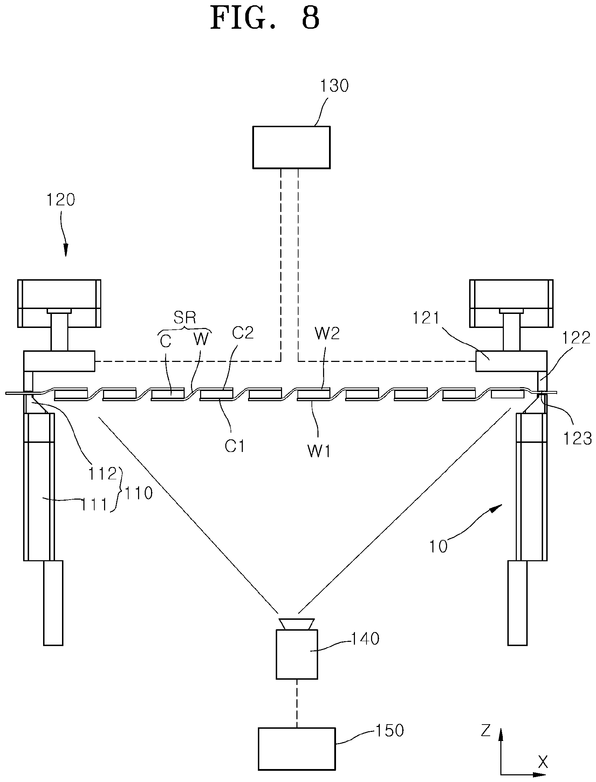

FIGS. 7 and 8 are schematic views showing an operation process of the inspection apparatus according to one embodiment of the present disclosure.

Referring to FIG. 7, the solar cell string SR is mounted on the first grip unit 110 in a state in which the solar cell string SR is disposed such that the first surface C1 faces downward.

In this case, the lower side surface of the first portion W1 of the wire W protruding from one end portion of the solar cell string SR may be brought into contact with the first gripper 112 provided in one of the pair of first grip units 110, and the lower side surface of the second portion W2 of the wire W protruding from the other end portion of the solar cell string SR may be brought into contact with the first gripper 112 provided in the other of the pair of first grip units 110.

Then, the second grip body 121 generates a driving force to move the second gripper 122 downward.

As the second gripper 122 moves downward more than a set distance, the second gripper 122 comes into contact with the upper side surface of the wire W.

In this case, the second gripper 122 provided in one of the pair of second grip units 120 may come into contact with the first portion W1 of the wire W protruding from one end portion of the solar cell string SR, and the second gripper 122 provided in the other of the pair of second grip units 120 may come into contact with the upper side surface of the second portion W2 of the wire W protruding from the other end portion of the solar cell string SR.

The second gripper 122 presses the wire W downward toward the first gripper 112, and the wire W is fixed between the first gripper 112 and the second gripper 122 by the pressing force applied from the first gripper 112 and the second gripper 122.

Then, the power supply unit 130 applies a current to the solar cell string SR through the second gripper 122.

As the current is applied to the solar cell string SR, an electroluminescence phenomenon in which infrared rays are emitted occurs on the first surface C1 of the solar cell string SR.

The detection unit 140 captures the electroluminescence image of the solar cell string SR and transmits the captured electroluminescence image to the control unit 150.

The control unit 150 calculates the brightness distribution of the solar cell cells C constituting the solar cell string SR based on the image of the solar cell string SR received from the detection unit 140 and determines whether the solar cell string SR is defective based on the calculated information.

Hereinafter, an inspection apparatus 2 according to another embodiment of the present disclosure will be described.

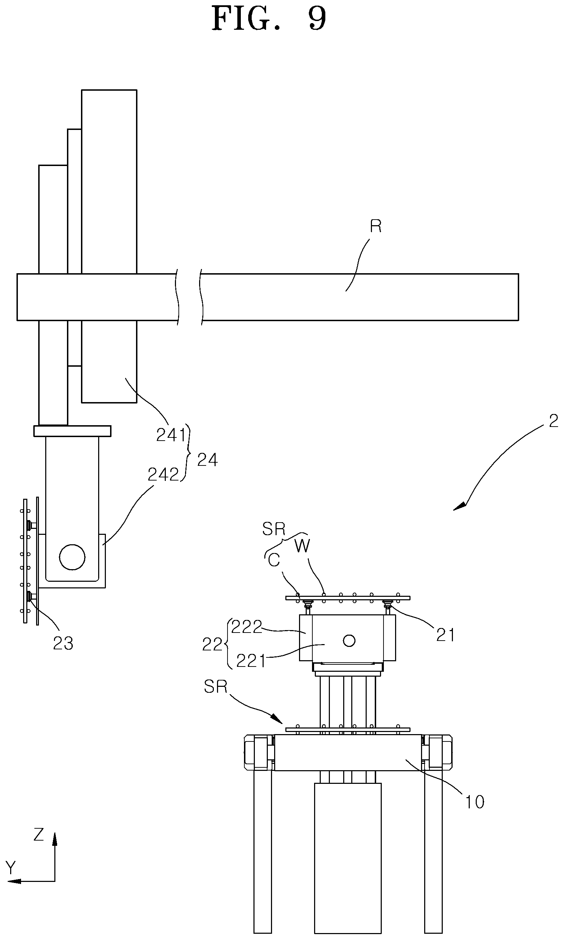

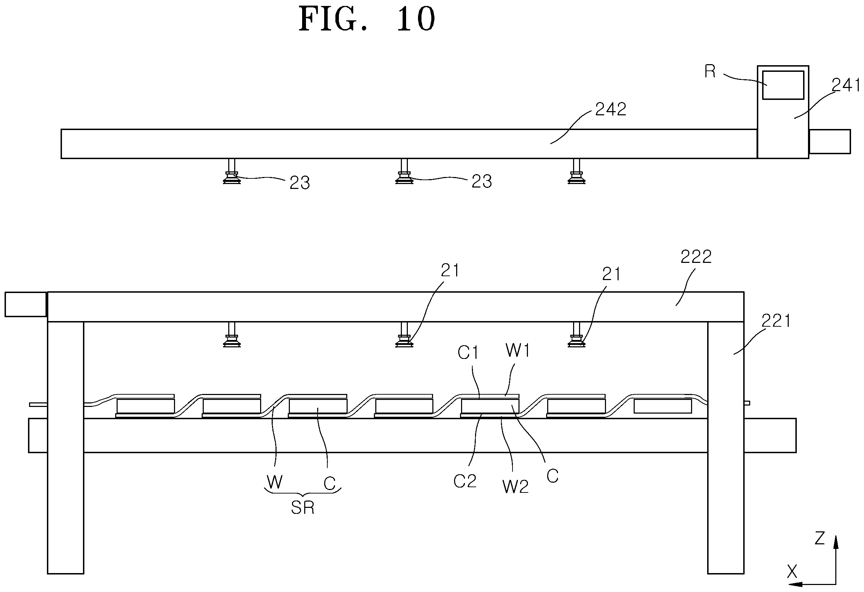

FIGS. 9 and 10 are schematic views showing a configuration of the inspection apparatus according to another embodiment of the present disclosure.

Referring to FIGS. 9 and 10, the inspection apparatus 2 according to the present embodiment is an apparatus for performing a visual inspection of a solar cell string SR manufactured through a tabbing process and includes a first adsorption member 21, a first driving unit 22, a second adsorption member 23, and a second driving unit 24.

The solar cell string SR to be described below may be the same as the solar cell string SR described in the one embodiment of the present disclosure. Additionally, a first direction and a second direction to be described below may be the same directions as the first direction and the second direction described in the one embodiment of the present disclosure.

In the present embodiment, the solar cell string SR may be transferred in the first direction by a supply unit 10 in a state in which the solar cell string SR is disposed such that the first surface C1 faces upward. The supply unit 10 may include various types of continuous supply devices such as a belt conveyor, a roller conveyor, a shuttle conveyor, etc. that may continuously transfer the solar cell string SR in the first direction.

The first adsorption member 21 may adsorb the first surface C1 of the solar cell string SR. The first adsorption member 21 according to the present embodiment may be disposed above the supply unit 10. The first adsorption member 21 may generate vacuum pressure to adsorb the first surface C1 of the solar cell string SR supplied by the supply unit 10. The first adsorption member 21 may be disposed such that one end portion for adsorbing the first surface C1 faces downward at an initial position. The first adsorption member 21 may be connected to a vacuum pressure generating device such as a vacuum pump via a hose, a pipe, etc.

A plurality of first adsorption members 21 may be provided. The plurality of first adsorption members 21 may be arranged at set intervals in the first direction.

The first driving unit 22 may be connected to the first adsorption member 21 and adjust a position of the first adsorption member 21.

The first driving unit 22 according to the present embodiment may include a first driving body 221 and a first rotating body 222.

The first driving body 221 may form the overall framework of the first driving unit 22 and support the first rotating body 222. A lower end portion of the first driving body 221 according to the present embodiment may be fixed to the ground. An upper end portion of the first driving body 221 may be reciprocally moved in the vertical direction by a driving force generated from a motor, a cylinder, etc. Accordingly, the first driving body 221 may adjust a vertical position of the first adsorption member 21 to prevent the first adsorption member 21 from interfering with the solar cell string SR during the operation of the first rotating body 222 which will be described below.

The first rotating body 222 may be rotatably connected to the first driving body 221 and support the first adsorption member 21. The first rotating body 222 according to the present embodiment may be connected to an upper end portion of the first driving body 221 to be rotatable around a direction parallel to the first direction. The first rotating body 222 may be moved clockwise or counterclockwise with respect to the first driving body 221 by a driving force generated from a motor or the like.

The other end portion of the first adsorption member 21 may be connected to the first rotating body 222 by various types of connecting methods such as welding and bolting. The first adsorption member 21 may be rotated around a direction parallel to the first direction together with the first rotating body 222 when the first rotating body 222 rotates. In this case, the direction in which one end portion of the first adsorption member 21 faces may be varied by a rotation angle of the first rotating body 222 from the initial position.

The second adsorption member 23 may adsorb the second surface C2 of the solar cell string SR adsorbed to the first adsorption member 21. That is, the second adsorption member 23 may function as a component that adsorbs the second surface C2 of the solar cell string SR in a state in which the first surface C1 of the solar cell string SR is adsorbed to the first adsorption member 21 and receives the solar cell string SR from the first adsorption member 21. Accordingly, the second adsorption member 23 may expose the first surface C1, which is a main light-receiving surface of the solar cell string SR on which the visual inspection is performed, to the outside.

The second adsorption member 23 according to the present embodiment may be disposed above the first adsorption member 21 and the first driving unit 22. The second adsorption member 23 may generate vacuum pressure to adsorb the second surface C2 of the solar cell string SR adsorbed to the first adsorption member 21. The second adsorption member 23 may be disposed such that one end portion for adsorbing the second surface C2 faces downward at an initial position. The second adsorption member 23 may be connected to a vacuum pressure generating device such as a vacuum pump via a hose, a pipe, etc.

A plurality of second adsorption members 23 may be provided. The plurality of second adsorption members 23 may be arranged at set intervals in the first direction. The interval between adjacent second adsorption members 23 may be the same as the interval between adjacent first adsorption members 21, or alternatively, may be different from the interval between adjacent first adsorption members 21.

The second driving unit 24 may be connected to the second adsorption member 23 and adjust a position of the second adsorption member 23.

The second driving unit 24 according to the present embodiment may include a second driving body 241 and a second rotating body 242.

The second driving body 241 may be spaced apart from the first driving body 221 and installed to move relative to the first driving body 221.

An upper end portion of the second driving body 241 according to the present embodiment may be reciprocally connected to a rail unit R disposed parallel to the second direction. The upper end portion of the second driving body 241 may be reciprocally moved in a direction parallel to the second direction by a driving force generated from a motor, a cylinder, etc. Accordingly, the second driving body 241 may adjust a horizontal position of the second adsorption member 23.

A lower end portion of the second driving body 241 may be reciprocally moved in the vertical direction by a driving force generated from a motor, a cylinder, etc. Accordingly, the second driving body 241 may adjust a vertical position of the second adsorption member 23.

The second rotating body 242 may be rotatably connected to the second driving body 241 and support the second adsorption member 23. The second rotating body 242 according to the present embodiment may be connected to a lower end portion of the second driving body 241 to be rotatable around a direction parallel to the first direction. The second rotating body 242 may be moved clockwise or counterclockwise with respect to the second driving body 241 by a driving force generated from a motor or the like.

The other end portion of the second adsorption member 23 may be connected to the second rotating body 242 by various types of connecting methods such as welding and bolting. The second adsorption member 23 may be rotated around a direction parallel to the first direction together with the second rotating body 242 when the second rotating body 242 rotates. In this case, the direction in which one end portion of the second adsorption member 23 faces may be varied by a rotation angle of the second rotating body 242 from the initial position.

Hereinafter, an operation process of the inspection apparatus 2 according to another embodiment of the present disclosure will be described.

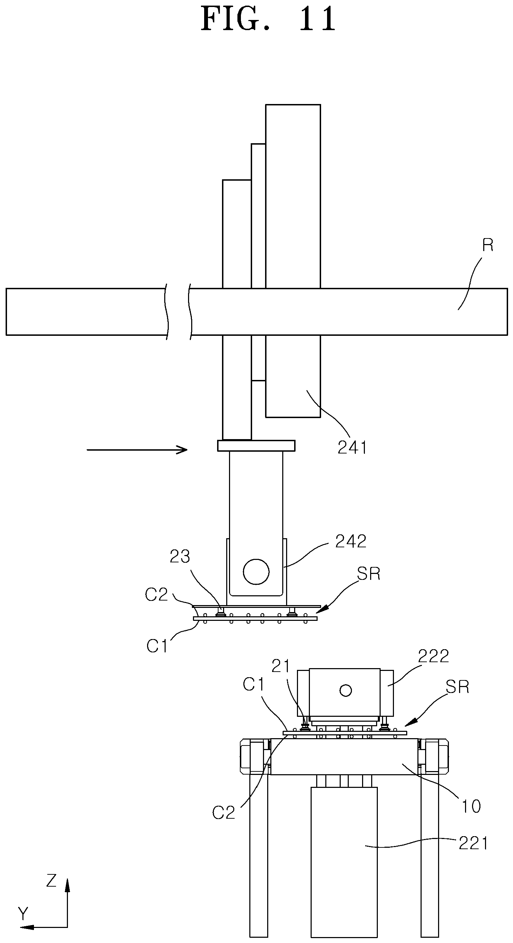

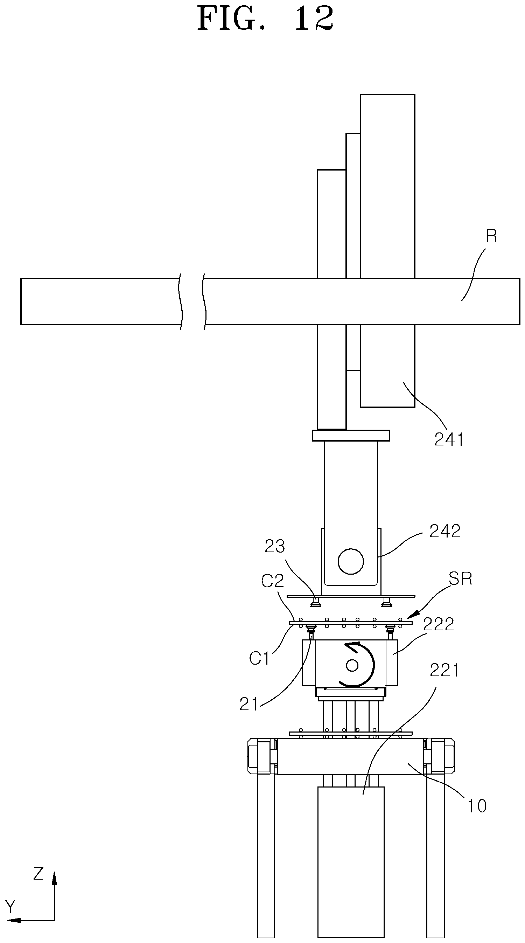

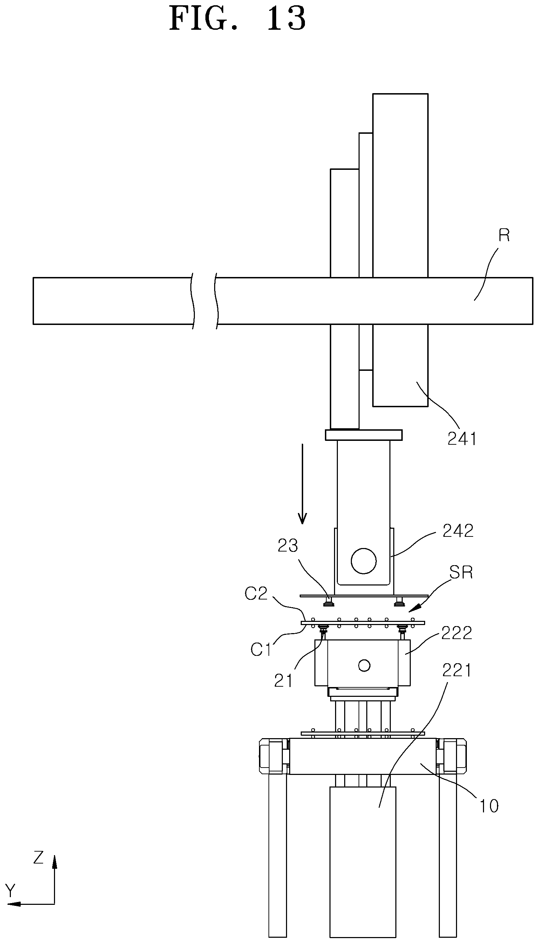

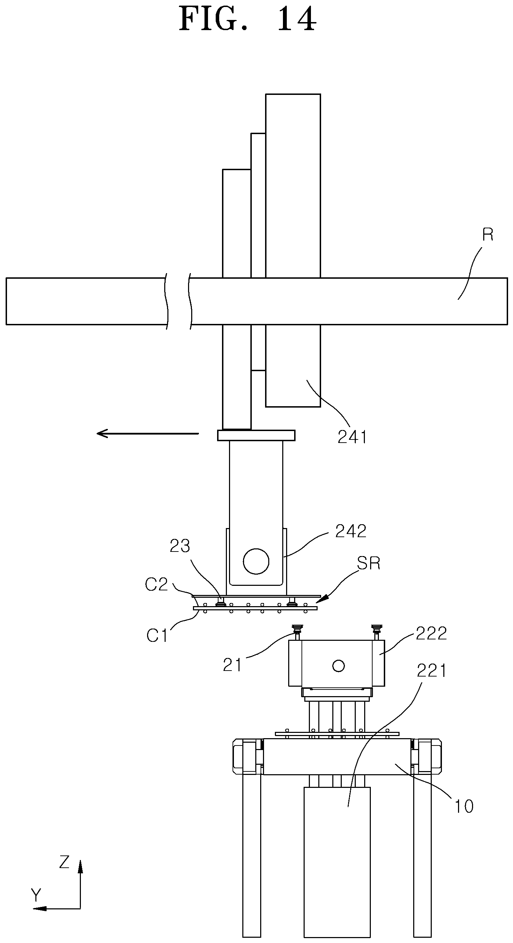

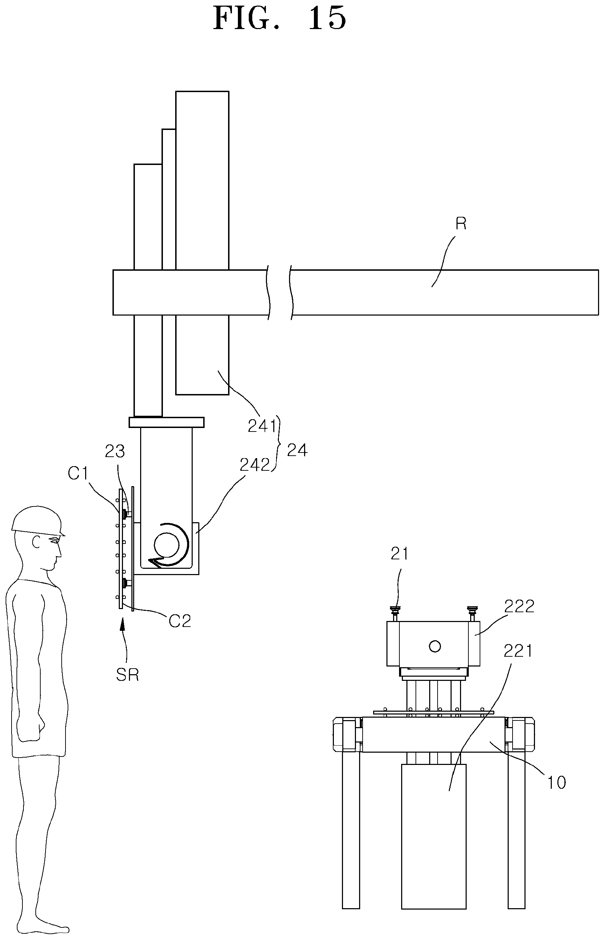

FIGS. 11 to 15 are schematic views showing the operation process of the inspection apparatus according to another embodiment of the present disclosure.

Referring to FIGS. 11 to 15, the first adsorption member 21 adsorbs the first surface C1 of the solar cell string SR supplied from the supply unit 10 in a state in which the first adsorption member 21 is positioned at the initial position.

The second driving body 241 is moved along the rail unit R, and the second adsorption member 23 is disposed to face the first adsorption member 21 vertically.

The first rotating body 222 is rotated around the first direction and rotates the first adsorption member 21 such that the second surface C2 of the solar cell string SR faces the second adsorption member 23.

As the second surface C2 of the solar cell string SR is disposed to face the second adsorption member 23, the second adsorption member 23 adsorbs the second surface C2 of the solar cell string SR, and the first adsorption member 21 releases the adsorption state to the first surface C1 of the solar cell string SR.

The second driving body 241 is moved along the rail unit R and moves the second adsorption member 23 to a position adjacent to the worker.

As the second adsorption member 23 is moved to a position adjacent to the worker, the second rotating body 242 is rotated around the first direction and rotates the second adsorption member 23 such that the first surface C1 of the solar cell string SR faces a set direction. Here, it is possible to variously change the design for the set direction within a range of a direction in which the first surface C1 is disposed to directly face the worker.

Then, the worker visually inspects the appearance quality of the first surface C1.

Hereinafter, an inspection apparatus 3 according to still another embodiment of the present disclosure will be described.

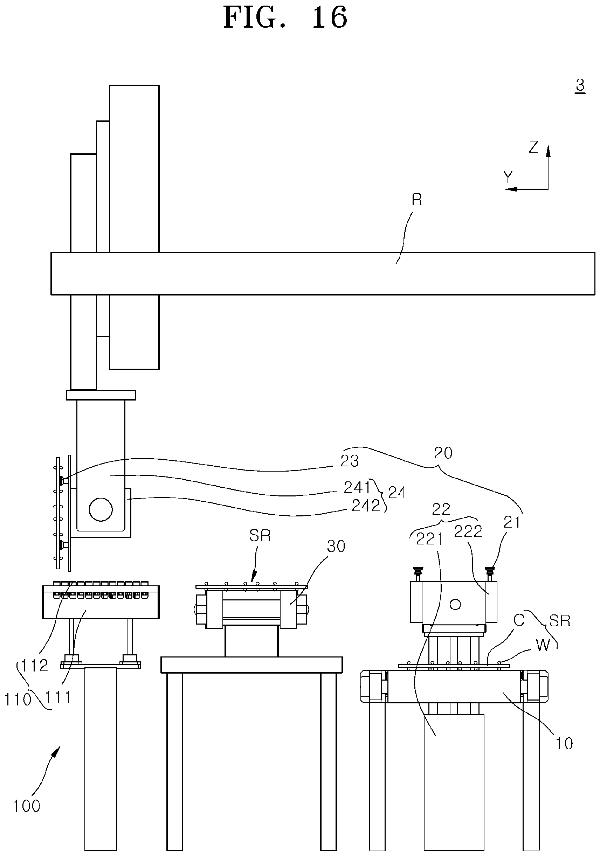

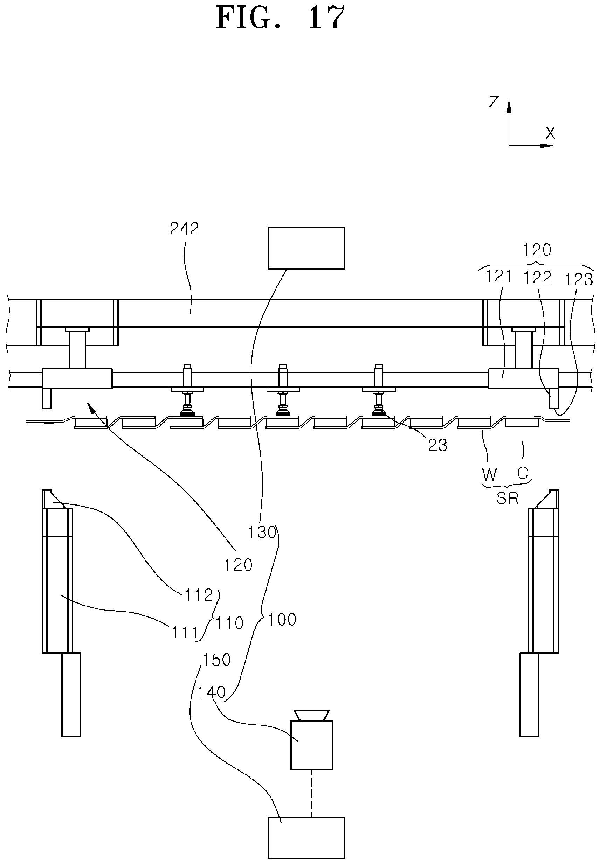

FIGS. 16 and 17 are schematic views showing a configuration of the inspection apparatus according to still another embodiment of the present disclosure.

Referring to FIGS. 16 and 17, the inspection apparatus 3 according to the present embodiment is an apparatus configured to perform both the visual inspection and the EL inspection on a solar cell string SR manufactured through a tabbing process, which is a combination of the above-described embodiments.

The inspection apparatus 3 according to the present embodiment includes a supply unit 10, a transfer unit 20, and an inspection unit 100.

The solar cell string SR to be described below may be the same as the solar cell string SR described in the above embodiments. Additionally, a first direction and a second direction, which will be described below, may be the same directions as the first direction and the second direction described in the above embodiments.

The supply unit 10 supplies the solar cell string SR. The supply unit 10 according to the present embodiment may be the same as the supply unit 10 according to another embodiment of the present disclosure described based on FIGS. 9 to 15.

The transfer unit 20 transfers the solar cell string supplied from the supply unit 10.

The transfer unit 20 according to the present embodiment may include a first adsorption member 21, a first driving unit 22, a second adsorption member 23, and a second driving unit 24.

The first adsorption member 21, the first driving unit 22, the second adsorption member 23, and the second driving unit 24 according to the present embodiment may be the same as the first adsorption member 21, the first driving unit 22, the second adsorption member 23, and the second driving unit 24 according to another embodiment of the present disclosure described based on FIGS. 9 to 15.

The inspection unit 100 may acquire an electroluminescence image of the solar cell string SR transferred from the transfer unit 20.

The inspection unit 100 according to the present embodiment may include a first grip unit 110, a second grip unit 120, a power supply unit 130, a detection unit 140, and a control unit 150.

The first grip unit 110, the second grip unit 120, the power supply unit 130, the detection unit 140, and the control unit 150 according to the present embodiment may be the same as the first grip unit 110, the second grip unit 120, the power supply unit 130, the detection unit 140, and the control unit 150 according to one embodiment of the present disclosure described based on FIGS. 1 to 8, except that the second grip unit 120 is connected to the second driving unit 24.

The second grip body 121 according to the present embodiment may be connected to the second rotating body 242. A plurality of second adsorption members 23 may be disposed between a pair of second grip units 120.

The second grip body 121 and the second gripper 122 may be rotated clockwise or counterclockwise around the first direction together with the second rotating body 242 when the second rotating body 242 rotates.

As the second adsorption member 23 is disposed such that the first surface C1 faces downward in a state in which the second adsorption member 23 adsorbs the solar cell string SR, the second gripper 122 may be disposed to face the first gripper 112 vertically.

The inspection apparatus 3 according to the present embodiment may further include a discharge unit 30.

The discharge unit 30 may function as a component for discharging the solar cell string SR that has been subjected to the visual inspection and EL inspection processes by the transfer unit 20 and the inspection unit 100 to the outside. The discharge unit 30 may receive the solar cell string SR from the transfer unit 20 after the visual inspection and EL inspection processes by the inspection unit 100 have been completed. The solar cell string SR determined to be normal as a result of the inspection may be delivered to the discharge unit 30. Additionally, the solar cell string SR determined to be defective as a result of the inspection may also be delivered to the discharge unit 30 and then separated from the solar cell string SR determined to be normal. Alternatively, although not shown in the drawing, the solar cell string SR determined to be defective may be delivered to a second discharge unit (not shown) separate from the discharge unit 30 and separated from the normal solar cell string SR.

The discharge unit 30 according to the present embodiment may include various types of continuous supply devices such as a belt conveyor, a roller conveyor, a shuttle conveyor, etc. that may continuously transfer the solar cell string SR in the first direction. The discharge unit 30 may be disposed between the supply unit 10 and the inspection unit 100. However, the shape, position, and transfer direction of the discharge unit 30 are not limited thereto, and the discharge unit 30 may be formed to have various shapes, positions, and transfer directions for discharging the solar cell string SR that has been subjected to the visual inspection and EL inspection by the transfer unit 20 and the inspection unit 100 to the outside.

Hereinafter, an operation process of the inspection apparatus 3 according to still another embodiment of the present disclosure will be described.

As the solar cell string SR is supplied from the supply unit 10, the transfer unit 20 performs the operations described based on FIGS. 11 to 15, and the worker performs a visual inspection of the solar cell string SR.

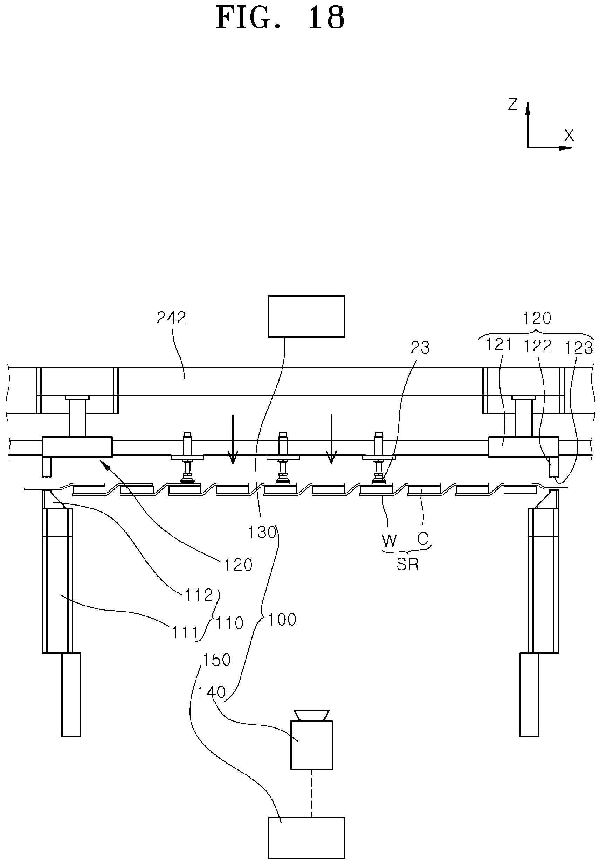

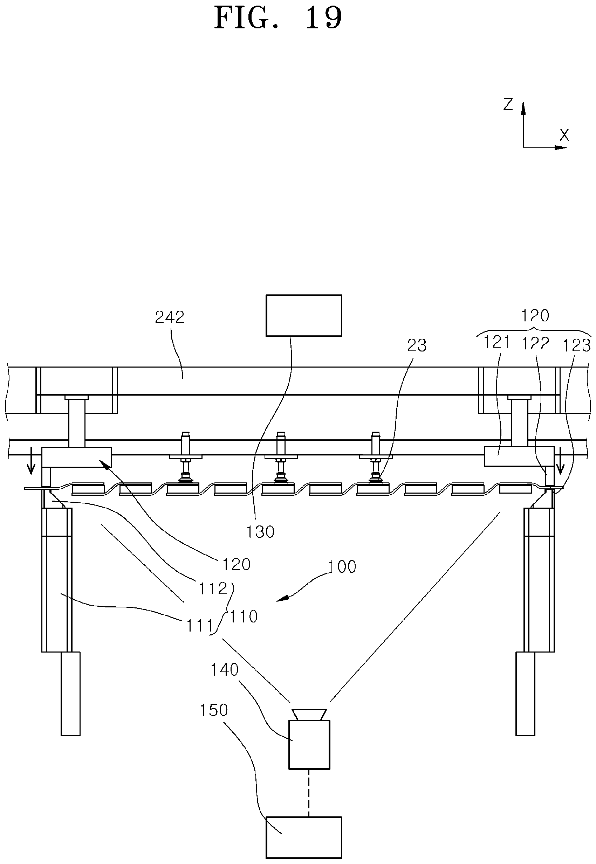

FIGS. 18 and 19 are schematic views showing the EL inspection process according to still another embodiment of the present disclosure.

After the visual inspection of the solar cell string SR is completed, the second rotating body 242 is rotated around the first direction and rotates the second grip unit 120 such that the first surface C1 of the solar cell string SR faces the ground.

As the solar cell string SR is disposed such that the first surface C1 faces the ground, the second driving body 241 moves downward, and the solar cell string SR is mounted on the upper surface of the first gripper 112.

Then, the inspection unit 100 performs the EL inspection on the solar cell string SR by the operations described based on FIGS. 7 and 8.

After the EL inspection on the solar cell string SR is completed, the second grip body 121 moves upward to release the pressing force on the wire W, and the second driving body 241 moves along the rail unit R such that the solar cell string SR faces the discharge unit 30.

Then, the second adsorption member 23 releases the adsorption state to the second surface C2, and the solar cell string SR is transferred in the first direction by the discharge unit 30 and discharged to the outside.

According to the present disclosure, since a first grip unit and a second grip unit align a gripping direction of a wire with a direction parallel to the direction of gravity, the first grip unit and the second grip unit can be in stable contact with the wires, and a solar cell string can be firmly supported.

According to the present disclosure, since the elastic member can absorb an impact generated during a wire gripping process, damage to and breakage of the wire generated during an inspection process can be prevented.

According to the present disclosure, since a first surface, which is a main light-receiving surface of a solar cell string supplied from a supply unit, is exposed to the outside by a multi-stage adsorption method using a first adsorption member and a second adsorption member, a smooth visual inspection can be performed.

According to the present disclosure, since a visual inspection and an EL inspection can be performed consecutively on a solar cell string manufactured through tabbing work, the efficiency of an inspection process can be improved and the time required for the inspection can be shortened.

Although the present disclosure has been described with reference to embodiments shown in the drawings, the embodiments are merely exemplary, and those skilled in the art will appreciate that various modifications and equivalent other embodiments are possible from the embodiments.

Therefore, the technical protection scope of the present disclosure should be determined based on the claims below.

## Claims

1. An inspection apparatus comprising:
a first grip unit on which a solar cell string having a solar cell and a wire is mounted;
a second grip unit that is disposed to face the first grip unit and presses the solar cell string toward the first grip unit;
a power supply unit that is connected to the second grip unit and supplies a current to the solar cell string; and
a detection unit that acquires image information on the solar cell string.

2. The inspection apparatus of claim 1, wherein the first grip unit and the second grip unit are disposed to face each other in a vertical direction.

3. The inspection apparatus of claim 1, wherein the first grip unit includes:
a first grip body; and
a first gripper that extends from the first grip body and comes into contact with the wire.

4. The inspection apparatus of claim 3, wherein a cross-sectional area of the first gripper decreases toward the solar cell string.

5. The inspection apparatus of claim 3, wherein the first gripper is movably connected to the first grip body, and
the first grip unit further includes an elastic member provided between the first gripper and the first grip body.

6. The inspection apparatus of claim 3, wherein the first grip unit further includes a guide groove which is formed to be recessed inward of the first gripper and into which the wire is inserted.

7. The inspection apparatus of claim 3, wherein the second grip unit includes:
a second grip body that is spaced apart from the first grip body and generates a driving force; and
a second gripper that is moved by receiving the driving force from the second grip body and presses or releases the wire toward or from the first gripper depending on a movement direction.

8. The inspection apparatus of claim 7, wherein the second grip unit further includes a pressing protrusion that protrudes from the second gripper and comes into contact with the wire.

9. The inspection apparatus of claim 8, wherein a cross-sectional area of the pressing protrusion is smaller than a cross-sectional area of the second gripper.

10. An inspection apparatus comprising:
a first adsorption member that adsorbs a first surface of a solar cell string;
a first driving unit that adjusts a position of the first adsorption member;
a second adsorption member that is spaced apart from the first adsorption member and adsorbs a second surface opposite to the first surface adsorbed to the first adsorption member; and
a second driving unit that adjusts a position of the second adsorption member.

11. The inspection apparatus of claim 10, wherein the first driving unit includes:
a first driving body; and
a first rotating body that supports the first adsorption member and is rotatably connected to the first driving body, and
the first rotating body rotates the first adsorption member such that the second surface faces the second adsorption member after the first adsorption member absorbs the first surface.

12. The inspection apparatus of claim 11, wherein the second driving unit includes:
a second driving body that is spaced apart from the first driving body and is installed to move relative to the first driving body; and
a second rotating body that is rotatably connected to the second driving body and supports the second adsorption member, and
the second rotating body rotates the second adsorption member such that the first surface faces in a set direction after the second adsorption member has absorbed the second surface.

13. An inspection apparatus comprising:
a supply unit that supplies a solar cell string;
a transfer unit that transfers the solar cell string supplied from the supply unit; and
an inspection unit that acquires an electroluminescence image of the solar cell string transferred from the transfer unit.

14. The inspection apparatus of claim 13, wherein the solar cell string includes a first surface and a second surface which are opposite to each other, and
the transfer unit includes:
a first adsorption member that adsorbs the first surface;
a first driving unit that adjusts a position of the first adsorption member;
a second adsorption member that is spaced apart from the first adsorption member and adsorbs the second surface of the solar cell string adsorbed to the first adsorption member; and
a second driving unit that adjusts a position of the second adsorption member.

15. The inspection apparatus of claim 13, wherein the solar cell string includes a solar cell and a wire, and
the inspection unit includes;
a first grip unit on which the solar cell string is mounted;
a second grip unit that is disposed to face the first grip unit, is connected to the transfer unit, and presses the solar cell string toward the first grip unit;
a power supply unit that is connected to the second grip unit and supplies a current to the solar cell string; and
a detection unit that acquires image information on the solar cell string.
